# EUROPEAN PATENT SPECIFICATION

(11) **EP 0 536 393 B1**
(45) Date of publication and mention of the grant of the patent: **29.11.1995**
(21) Application number: 92923347.6
(22) Date of filing: 26.04.1991
(51) Int. Cl.: H05K 7/14, G11B 33/12

(54) **REMOVABLE ELECTRICAL UNIT**
DEMONTIERBARE ELEKTRISCHE EINHEIT
BOITIER ELECTRIQUE DEMONTABLE

(43) Date of publication of application: 14.04.1993
(73) Proprietor: INTERNATIONAL BUSINESS MACHINES CORPORATION, Armonk, NY 10504 (US); SOLENT & PRATT (ENGINEERING) LIMITED, Bridport, Dorset DT6 3BS (GB)
(72) Inventor: GRAY, David, John 89 Queens Crescent, Nr Fareham Hampshire P01 4ZQ (GB); GOLLEDGE, Ian Buddy's Barn, Hampshire S051 9BU (GB); SPAKE, Steven, Richard 215 Botley Road, Hampshire S03 7BJ (GB)
(74) Representative: Burt, Roger James, Dr.
(86) International application number: GB9100669
(87) International publication number: WO9220206

(56) References cited:
- DE-A- 2 002 350
- DE-A- 3 013 517
- DE-B- 1 282 756
- IBM TECHNICAL DISCLOSURE BULLETIN, vol. 33, no. 6B, November 1990, New York, US; "Removable and transportable DASD", pages 76-77

## Description

### Technical Field of the Invention

This invention relates to the field of electrical units which are removable from their housing.

### Background of the Invention

A current trend in the design of electrical systems is the provision of modular configurations whereby the individual electrical devices making up the system are removable from the system housing. Such systems provide a number of advantages. The customer is able to buy a system which has a combination of different device types tailored to his own requirements. In addition, the manufacturer is able to offer a large number of different systems based on a smaller range of individual device types. If a device becomes defective, it can be removed for repair and replaced with a good device without seriously degrading the performance of the system as a whole.

One type of multi component system is a mass data storage subsystem which comprises removable data storage devices, e.g. disk drives, mounted in a chassis which also contains associated device controllers, power supplies and cooling fans.

With removable disk drives, extra provision in the form of improved shock mounts is commonly required to provide protection for the head disk assembly during handling. Although it may be possible to provide protection sufficient to cope with most handling conditions, it is extremely difficult to achieve such a level of protection within the limited space of a fixed form factor e.g. 13.33 cm (5.25 inches). Care is also needed when inserting or removing the disk drive into or from the chassis in order to avoid damage to the head disk assembly.

An article entitled 'Removable and Transportable DASD' (IBM Technical Disclosure Bulletin vol.33 No.6B November 1990 pp 76-77) describes a disk file module which is designed to be removably installed in the chassis of a user system. The module includes a first handle on its front surface for use in removing the module from either rack or tower mounting chassis. A second handle which folds flat at the top of the unit may be used an additional carrying aid.

A similar arrangement is employed in the EMR removable disk subsystem manufactured by Emulex Corporation. A pair of removable Portable Disk Modules (PDM) are mounted in a chassis and each module has a front mounted handle and a second handle hingeably attached to its top surface. The second handle is presumably used to assist in removal of the module from the chassis.

A similar arrangement is also known from DE-B-1 282 756.

### Disclosure of the Invention

Accordingly, the invention provides a removable electrical unit for location in the chassis of an electrical apparatus, the unit including catch means mounted on an outer surface thereof and adapted to engage with stop means mounted on an inner surface of the chassis when the unit is partly withdrawn from the chassis, thereby to prevent complete removal therefrom, the unit further including a combined grip and release mechanism in the form of a handle exposed by said partial withdrawal, which is operable to disengage the catch means from the stop means thereby to allow complete withdrawal of the unit from the chassis.

When the electrical unit is partially withdrawn from the chassis, the catch means and stop means engage thereby preventing complete removal. The combined grip and release mechanism on the unit is actuated to disengage the stop and catch means and the unit can then be completely removed from the chassis. In this way, the user is prevented from removing the unit in such a manner that may cause damage to the electrical/electronic components of the unit and is forced to use the handle in order to remove the unit from the chassis.

It is further preferred that when the unit is at the partly removed position, the handle is movable from a first position lying flush with the surface of the unit, where the latch is engaged with the stop, to a second position standing proud from the unit surface, where the latch is disengaged from the stop.

In a preferred arrangement, the stop means is resilient and deforms when engaged by the latch means when the unit reaches the partly removed position during removal of the unit from the chassis. In this way, the compressibility of the stop means provides a soft stop which avoids damage to sensitive components of the electrical unit which may possibly be caused by abrupt contact of the stop means and latch means during removal of the unit.

In a second aspect of the invention, there is provided an electrical apparatus comprising a chassis in which is mounted at least one removable electrical unit as claimed in the appended claims.

A preferred embodiment of the invention will now be described by way of example only with reference to the accompanying drawings.

### Brief Description of the Drawings

Figure 1 is an exploded perspective view of a data storage subsystem including removable disk drives;
Figure 2 is a perspective view of one of the removable disk drives of Fig. 1;
Figure 3 is a first perspective view of the interior of the housing of a Fig. 2 disk drive showing the release mechanism employed in the present invention;
Figure 4 is a more detailed view of the release mechanism shown in Fig. 3;
Figure 5 is a second perspective view of a Fig. 2 device excluding the release mechanism;
Figure 6 is a perspective view of the catch release mechanism as employed in the removable disk drive of Fig 2;
Figure 7A is a schematic view of the catch and release mechanism, with the stop block engaged with the stop spring;
Figure 7B is a schematic view of the catch and release mechanism, with the stop block disengaged from the stop spring;
Figure 7C is a schematic plan view of the stop spring and part of the stop block.

### Detailed Description of the Invention

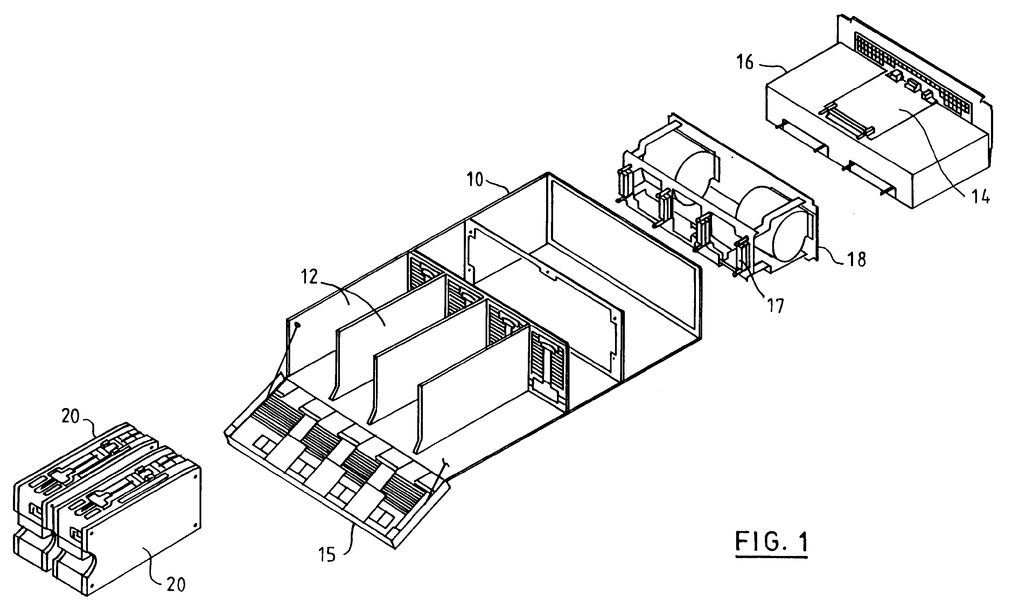

Referring to Figure 1, there is shown a data storage subsystem which comprises four removable disk drives 20 (two of which are shown) each of which is mountable into a corresponding device bay 12 in the front of the subsystem chassis 10. Cooling fans 18, a power supply 16 and disk drive controller card 14 are mounted in the chassis behind the disk drives. A device bay is defined by top, bottom and side walls of the chassis. Hingeably attached to the front of the chassis is a front cover 15. When it is desired to obtain access to the front of disk drives in order to remove them from the chassis, the front cover is pulled down to the position shown in Fig. 1.

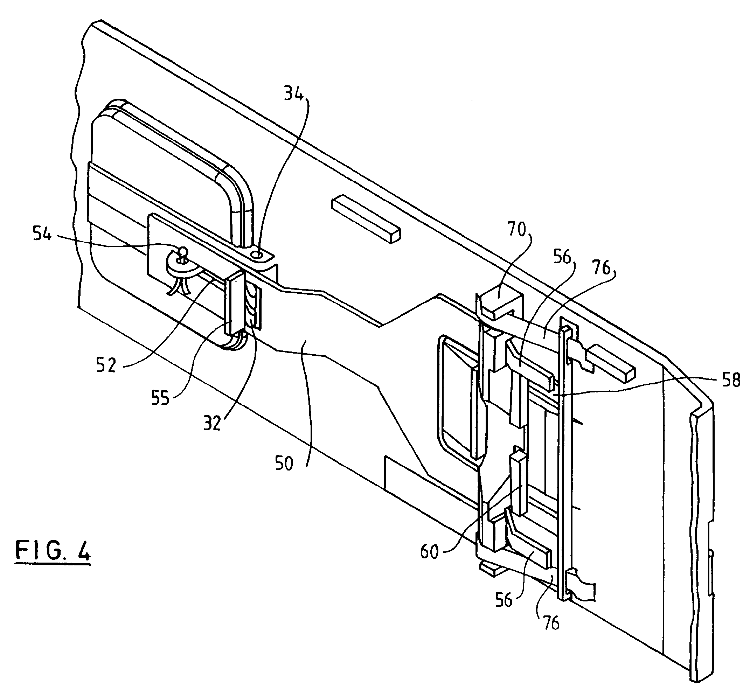

Each removable disk drive incorporates a soft stop and release mechanism which is employed to prevent removal of the unit from the chassis in an unsafe manner. As will be described in greater detail below, when the disk drive is partially removed from the chassis, a stop block unit 70 (see Figs. 4, 6 and 7) projecting from the top surface of the disk drive housing hits a stop spring 84 which is fixed to the inner surface 13 of the chassis. The release mechanism takes the form of a user operated top handle 30 which is connected to the stop block unit via a link plate 50. Actuation of the handle causes disengagement of the stop block and stop spring.

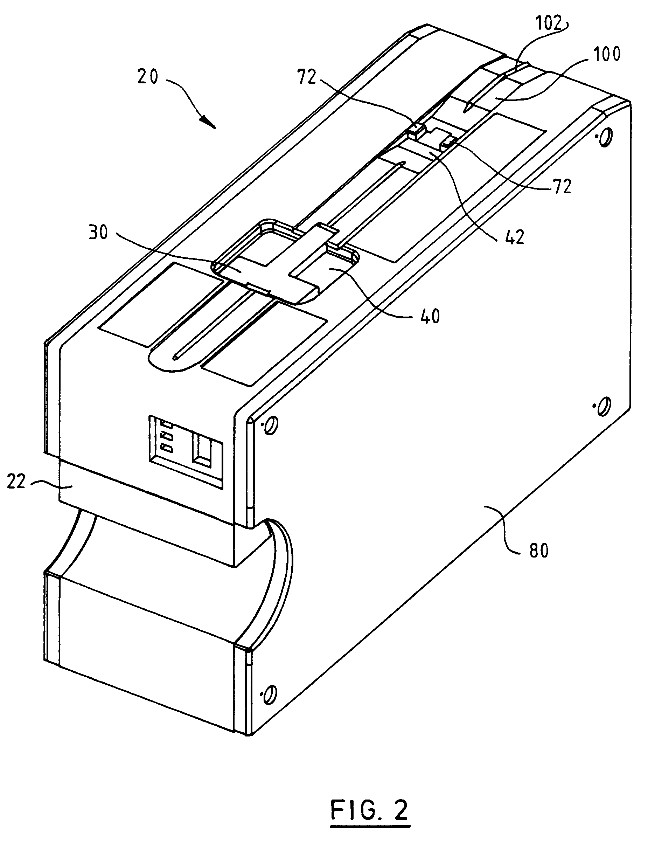

Fig. 2 shows the exterior of the disk drive housing 20 in which the head disk assembly and associated electronics are mounted. Extending along the top surface of the housing is a groove 100 which is divided longitudinally into two portions by a central rib 102. The rib provides a sacrificial wear strip to prevent damage to the top surface of the unit during insertion and withdrawal into and out of the chassis. Recesses in the top surface interrupt the groove in two positions. The top handle 30 of the release mechanism is positioned in a first recess 40 nearest the front surface of the housing. Projections 72 on the stop block unit 70 protrude through an aperture in the housing into a second recess 42 nearer the rear of the housing. The housing also includes a front handle 22 on its front surface which is used to pull the device from the system chassis.

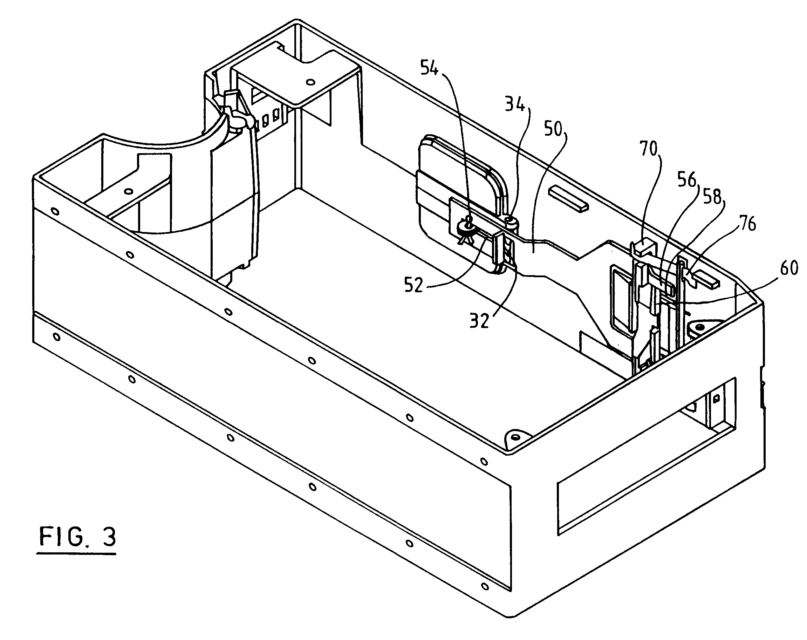

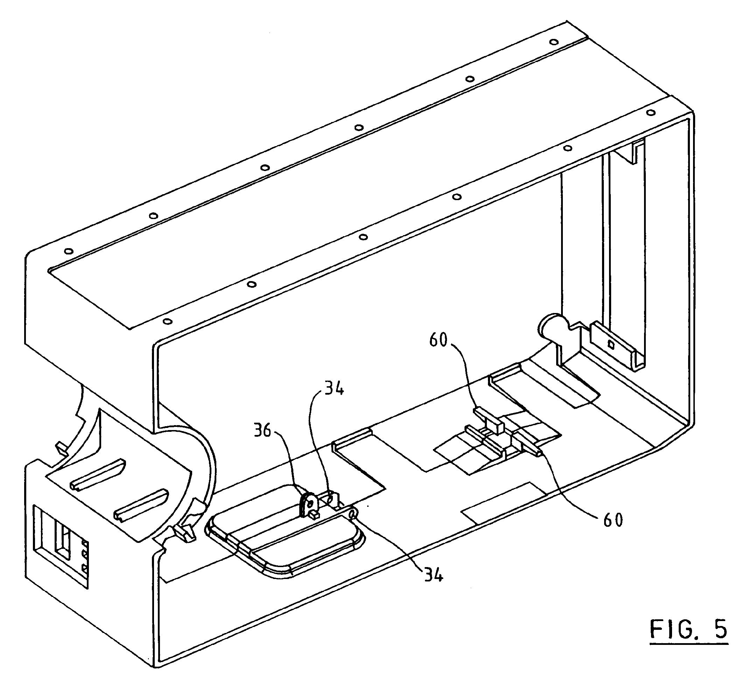

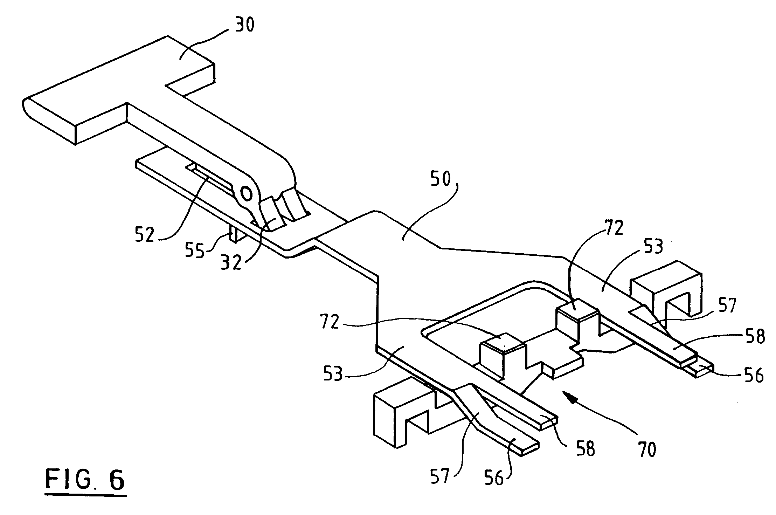

Fig. 3 shows the interior of the disk drive housing with the sidewall 80 (Fig.2) and the head disk assembly removed in order to show the release mechanism and stop block unit. The top handle shown in Fig. 2 is hingeably attached to the housing by means of a hinge pin which passes through the handle and through a pair of holes 34 defined on the inner surface of the housing (seen best in Figure 5). The top handle includes two teeth 32 which pass through an opening in the top surface of the housing and engage in corresponding slots in the link plate 50 (Fig. 6). One end of the link plate is held in position adjacent the inner surface of the housing by a split pin 54 which passes through a hole in a pillar 36 (Fig.5) standing proud of the housing inner surface. The pillar passes through a slot 52 in the link plate. Two prongs 58 at the other end of the link plate locate under a pair of ears 60 which are part of the housing casting. The link plate is free to move along the length of the housing to an extent limited by the length of the link plate slot.

The stop block unit 70 shown in Figure 6 fits into a recess in the housing adjacent to the cast ears. Two upwardly extending projections 72 of the unit protrude through an aperture in the housing. Two retaining springs 76 fixed on the inner surface of the housing bear against the ends of the stop block unit thereby holding it place in the disk drive housing. When the release mechanism is assembled in the disk drive housing, two fingers 56 of the link plate bear against angled faces 74 of the stop block unit.

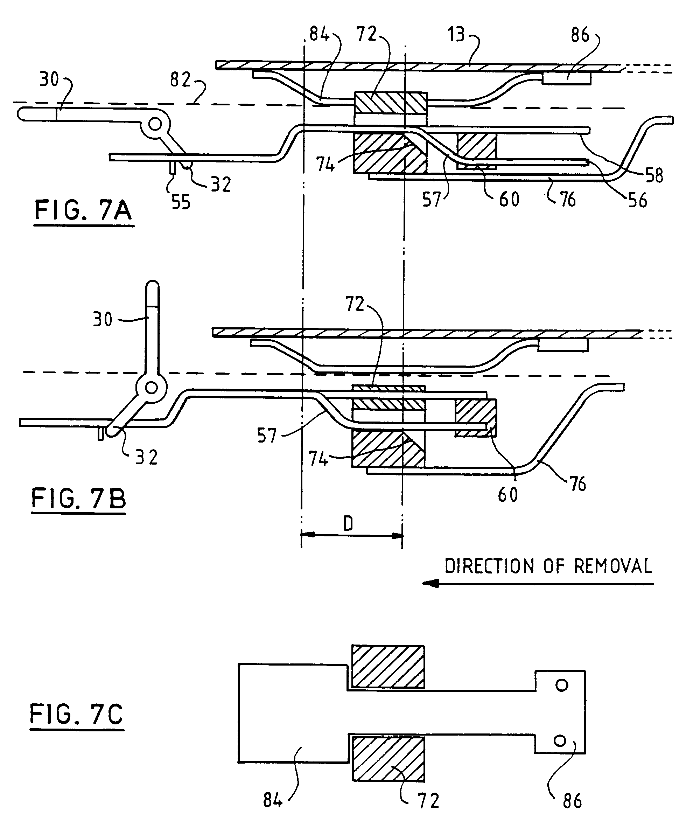

Fig 7 shows, in schematic form, the removable disk drive in two positions with respect to the chassis. In Fig. 7A, the disk drive is partly removed from the chassis with the top handle in the down position and the stop block against the stop spring. Fig. 7B shows the removable disk drive with the top handle in the up position and the stop block disengaged from the stop spring. The distance moved by the link plate during actuation of the handle is indicated by 'D' in Fig. 7. Fig. 7C is a plan view of the position of the stop spring 84 relative to the stop block projections 72.

In operation, the disk drive is removed from the chassis until the projections 72 engage the stop spring 84 which is fixed at one end 86 to the inner top surface 13 of the chassis (Figure 7A). The resilience of the stop spring is designed to provide a 'soft stop' so as to avoid damage to the head disk assembly when the projections hit the stop spring. In this position, the front portion of the disk drive (e.g. half of the length of the disk drive) projects beyond the front of the chassis. Dotted line 82 indicates the position of the top surface of the disk drive. In this position, the top handle is accessible to the operator (when the disk drive is fully inserted in the chassis, the top handle is not accessible). To delatch the stop block from the stop spring, the handle is raised to the upright position thereby causing the teeth 32 at the end of the handle to bear against bearing surface 55 thereby moving the link plate into the position shown in Fig. 7B. The link plate moves with respect to the housing and angled faces 57 on the link plate engage angled surfaces 74 of the stop block. Because the prongs 58 of the link plate are held under the cast ears of the housing, the fingers 56 force the stop block down relative to the disk drive housing and against the retaining spring 76. This causes the stop block to clear the stop spring and the disk drive can then be removed from the chassis in a safe two handed manner.

When the removable disk drive is inserted into the chassis, the stop spring mounted in the chassis rides on the central rib on the top surface of the disk drive. The spring passes over the stop block projections 72, forcing the stop block down against the retaining spring. When the stop spring has passed over the stop block projections, the retaining spring pushes the stop block unit in to position with the projections protruding through the aperture in the housing. The spring gives a constant pressure onto the removable device which provides a controlled insertion of the device into the chassis thus protecting the connector at the rear of the device and head disk assembly from shock. Thus, the operator cannot insert the device at a velocity which could cause damage. Furthermore, the stop spring is in constant contact with the disk drive housing during insertion and provides a grounding path from the chassis to the removable disk drive and also provides Radio Frequency Interference (RFI) suppression.

When the drive is fully inserted into its bay, a connector (not shown) at the rear of the disk drive mates with a corresponding connector 17 on the fan assembly 18. Cabling (not shown) connects the disk drive via connector 17 to the controller card and power supply. While not essential for carrying out the present invention, details of the connectors and technique by which the disk drive may be latched and locked in position in the chassis can be found in co-pending international application PCT/GB 91/00253 filed 19.02.91.

## Claims

1. Removable electrical unit (20) for location in the chassis (10) of an electrical apparatus, characterized in that the unit (20) includes catch means (70, 72) mounted on an outer surface thereof and adapted to engage with stop means (84, 86) mounted on an inner surface (13) of the chassis (10) when the unit (20) is partly withdrawn from the chassis (10), thereby to prevent complete removal therefrom, the unit (20) further including a combined grip and release mechanism in the form of a handle (30), exposed by said partial withdrawal, which is operable to disengage the catch means (70, 72) from the stop means (84, 86) thereby to allow complete withdrawal of the unit (20) from the chassis (10).

2. A removable electrical unit as claimed in claim 1, wherein when the unit (20) is at said partly withdrawn position, the handle (30) is movable from a first position lying flush with the surface of the unit, where the catch (70, 72) is engaged with the stop (84, 86), to a second position standing proud from the unit surface, where the catch (70, 72) is disengaged from the stop (84, 86).

3. A removable unit as claimed in claim 1 or claim 2 further comprising a second handle (22) at the front of the unit (20) for use in withdrawing the unit (20) from the chassis (10) to said partly withdrawn position.

4. A removable electrical unit as claimed in any preceding claim wherein the stop means (84, 86) is resilient and is deformable when engaged by the catch means (70, 72) when the unit (20) reaches said partly withdrawn position during withdrawal of the unit (20) from the chassis (10).

5. A removable electrical unit as claimed in claim 4, wherein the catch means comprises a stop block (70, 72) protruding from the outer surface of the unit and the stop means is a spring (84) which is fixed at one end (86) to the inner surface (13) of the chassis (10).

6. A removable electrical unit as claimed in claim 5 wherein the handle (30) is connected to the stop block (70, 72) by means of a movable link plate (50), wherein when the unit (20) is in said partly removed position, movement of the handle (30) from first to second position causes the link plate (50) to bear against the stop block (70, 72) to cause the stop block (70, 72) to disengage from the stop means (84, 86).

7. A removable electrical unit as claimed in claim 6 further comprising a retaining spring (76) fixed to the inner surface of the housing and arranged to engage the lower surface of the stop block (70) wherein when said handle (30) is moved from first to second position, the stop block (70) bears against the retaining spring (76).

8. Electrical apparatus comprising a chassis (10) in which is mounted at least one removable electrical unit (20) as claimed in any preceding claim.

## Patentansprüche

1. Demontierbare elektrische Einheit (20) zum Einbau in den Rahmen (10) eines elektrischen Geräts, dadurch gekennzeichnet, daß die Einheit (20) Verriegelungsmittel (70, 72) umfaßt, die an einer ihrer Außenflächen angebracht sind und in Anschlagmittel (84, 86) an einer Innenfläche (13) des Rahmens (10) eingreifen, wenn die Einheit (20) teilweise aus dem Rahmen (10) herausgezogen ist, so daß ein vollständiges Herausziehen aus dem Rahmen verhindert wird, wobei die Einheit (20) weiter einen kombinierten Greif- und Ausklinkmechanismus in Form eines Griffs (30) umfaßt, der durch das genannte teilweise Herausziehen freigelegt wird, der das Verriegelungsmittel (70, 72) aus dem Anschlagmittel (84, 86) ausklinken kann, wodurch die Einheit (20) komplett aus dem Rahmen (10) herausgezogen werden kann.

2. Eine demontierbare elektrische Einheit nach Anspruch 1, bei der, wenn die Einheit (20) sich in der genannten teilweise herausgezogenen Position befindet, der Griff (30) aus einer ersten Position, in der er mit der Oberfläche der Einheit bündig abschließt, und in der die Verriegelung (70, 72) in den Anschlag (84, 86) eingreift, in eine zweite Position bewegt werden kann, in der er über die Oberfläche der Einheit herausragt, und in der die Verriegelung (70, 72) aus dem Anschlag (84, 86) ausgeklinkt ist.

3. Eine demontierbare Einheit nach Anspruch 1 oder Anspruch 2, weiter einen zweiten Griff (22) vorne an der Einheit (20) umfassend, der zum Herausziehen der Einheit (20) aus dem Rahmen (10) in die genannte teilweise herausgezogene Position dient.

4. Eine demontierbare elektrische Einheit nach jedem vorangehenden Anspruch, bei der das Anschlagmittel (84, 86) elastisch und verformbar ist, wenn das Verriegelungsmittel (70, 72) in das Anschlagmittel eingreift, wenn die Einheit (20) beim Herausziehen der Einheit (20) aus dem Rahmen (10) die teilweise herausgezogene Position erreicht.

5. Eine demontierbare elektrische Einheit nach Anspruch 4, bei der das Verriegelungsmittel einen Anschlagblock (70, 72) umfaßt, der aus der Außenfläche der Einheit herausragt, und bei der das Anschlagmittel eine Feder (84) ist, die an einem Ende (86) an der Innenfläche (13) des Rahmens (10) befestigt ist.

6. Eine demontierbare elektrische Einheit nach Anspruch 5, bei der der Griff (30) über eine bewegliche Verbindungsplatte (50) mit dem Anschlagblock (70, 72) verbunden ist, und wobei, wenn die Einheit (20) sich in der teilweise herausgezogenen Position befindet, die Bewegung des Griffs (30) aus der ersten in die zweite Position dazu führt, daß die Verbindungsplatte (50) sich gegen den Anschlagblock (70, 72) abstützt und bewirkt, daß der Anschlagblock (70, 72) aus dem Anschlagmittel (84, 86) ausgeklinkt wird.

7. Eine demontierbare elektrische Einheit nach Anspruch 6, weiter eine an der Innenfläche des Gehäuses befestigte Haltefeder (76) umfassend, die um die untere Fläche des Anschlagblocks (70) herumgreift, bei der, wenn der genannte Griff (30) aus der ersten in die zweite Position bewegt wird, der Anschlagblock (70) sich gegen die Haltefeder (76) abstützt.

8. Elektrisches Gerät mit einem Rahmen (10), in dem mindestens eine demontierbare elektrische Einheit (20) nach jedem vorangehenden Anspruch montiert ist.

## Revendications

1. Boîtier électrique (20) démontable, destiné à être placé dans le châssis (10) d'un appareil électrique, caractérisé en ce que le boîtier (20) comprend des moyens de saisie (70, 72) montés sur sa surface extérieure et adaptés pour coopérer avec des moyens de butée (84, 86) montés sur une surface intérieure (13) du châssis (10) lorsque le boîtier (20) est partiellement extrait du châssis (10), de manière à empêcher son enlèvement complet, le boîtier (20) comprenant en outre un mécanisme de saisie et de libération combiné, se présentant sous la forme d'une manette (30) exposée suite à ladite extraction partielle, mécanisme susceptible de fonctionner pour désolidariser le moyen de saisie (70, 72) vis-à-vis des moyens de butée (84, 86), de manière à permettre l'enlèvement complet du boîtier (20) hors du châssis (10).

2. Boîtier électrique démontable selon la revendication 1, dans lequel le boîtier (20) se trouve en ladite position d'enlèvement partiel, la manette (30) étant déplaçable, depuis une première position, affleurée vis-à-vis de la surface du boîtier, dans laquelle l'organe de saisie (70, 72) est en contact avec la butée (84, 86), vers une deuxième position en saillie vis-à-vis de la surface du boîtier, dans laquelle le moyen de saisie (70, 72) est désolidarisé de la butée (84, 86).

3. Boîtier démontable selon la revendication 1 ou la revendication 2, comprenant en outre une deuxième manette (22) à l'avant du boîtier (20), destinée à être utilisée lors de l'enlèvement du boîtier (20) vis-à-vis du châssis (10) lorsqu'il se trouve dans ladite position partiellement enlevée.

4. Boîtier électrique démontable selon l'une quelconque des revendications précédentes, dans lequel les moyens de butée (84, 86) sont élastiques et déformables lorsqu'ils sont en contact avec les moyens de saisie (70, 72), lorsque le boîtier (20) atteint ladite position partiellement enlevée lors de l'enlèvement du boîtier (20) hors du châssis (10).

5. Boîtier électrique démontable selon la revendication 4, dans lequel le moyen de saisie comprend un bloc de butée (70, 72) faisant saillie de la surface extérieure du boîtier et les moyens de butée étant constitués d'un ressort (84) fixé à une extrémité (86) à la surface intérieure (13) du châssis (10).

6. Boîtier électrique démontable selon la revendication 5, dans lequel la manette (30) est reliée au bloc de butée (70, 72) au moyen d'une plaque articulée mobile (50), dans lequel, lorsque le boîtier (20) se trouve dans ladite position partiellement enlevée, le déplacement de la manette (30), fait pour le passage de la première à la deuxième position, provoque la portée de la plaque articulée (50) contre le bloc de butée (70, 72), de manière à provoquer le dégagement du bloc de butée (70, 72) vis-à-vis du moyen de butée (84, 86).

7. Boîtier électrique démontable selon la revendication 6, comprenant en outre un ressort de retenue (76), fixé à la surface intérieure du boîtier et agencé pour venir en contact avec la surface inférieure du bloc de butée (70), dans lequel, lorsque ladite butée (30) est déplacée depuis la première à la deuxième position, le bloc de butée (70) porte contre le ressort de retenue (76).

8. Appareil électrique comprenant un châssis (10), dans lequel est monté au moins un boîtier électrique démontable (20) selon l'une quelconque des revendications précédentes.
